# EUROPEAN PATENT APPLICATION

(11) **EP 4 407 678 A1**
(43) Date of publication of application: **31.07.2024**
(21) Application number: 23878359.1
(22) Date of filing: 26.09.2023
(51) Int. Cl.: H01L 23/544, H01L 21/66, H01L 23/48, G01R 31/00

(54) **CHIP TESTING STRUCTURE AND CHIP TESTING METHOD**

(30) Priority: 14.12.2022 CN 202211608708
(71) Applicant: Hygon Information Technology Co., Ltd., Tianjin 300392 (CN)
(72) Inventor: XUE, Xiaodi, Tianjin 300392 (CN)
(74) Representative: Maiwald GmbH
(86) International application number: PCT/CN2023/121376
(87) International publication number: WO 2024/125033

(57) **Abstract**

The embodiments of the present disclosure provide a chip testing structure and a chip testing method, the chip testing structure includes: an interposer, a plurality of chips on the interposer, and a plurality of test points on the interposer. The plurality of the test points are connected in series, an electrical connecting wire of the plurality of the test points is provided in an interposer wiring layer of the interposer, and an electrical connecting wire of adj acent test potentials includes a plurality of sub-connecting wires, different sub-connecting wires are positioned at different heights of the interposer wiring layer, and the plurality of the sub-connecting wires are connected sequentially based on a height of the interposer wiring layer. When test potentials of the plurality of the test points indicate an open circuit connection, the interposer is indicated to be fragmented or have a crack. The embodiments of the present disclosure can accurately and efficiently determine whether the interposer is fragmented or has a crack, implementing the detection for the interposer in the whole process of the packaging procedure.

## Description

### CROSS-REFERENCE TO RELATED APPLICATION

The present application claims priority of the Chinese Patent Application No. 202211608708.6, filed on December 14, 2022, the disclosure of which is incorporated herein by reference in its entirety as part of the present application.

### TECHNICAL FIELD

The embodiments of the present disclosure relate to a chip testing structure and a chip testing method.

### BACKGROUND

The manufacturing process of a chip is mainly divided into several steps: wafer fabrication, packaging, and test. However, when a chip die is packaged through an interposer, the interposer has a certain stress effect, easily causing the interposer to be fragmented or have a crack in the chip packaging process, and causing a poor quality of the packaged chip.

Thus, how to detect that whether the interposer is fragmented or has a crack in the whole process of the packaging is a technical problem that is urgently needed to be solved by those skilled in the art.

### SUMMARY

In light of the above, the embodiments of the present disclosure provide a chip testing structure and a chip testing method, which can accurately and efficiently determine whether an interposer is fragmented or has a crack, implementing the test for the interposer in the whole process of the packaging.

In order to solve the above problem, the embodiments of the present disclosure provide the following technical solution.

In the first aspect, the embodiments of the present disclosure provide a chip testing structure, which includes: an interposer, a plurality of chips on the interposer, and a plurality of test points on the interposer.

The plurality of the test points are connected in series, an electrical connecting wire of the plurality of the test points is provided in an interposer wiring layer of the interposer, and an electrical connecting wire of adjacent test potentials includes a plurality of sub-connecting wires, different sub-connecting wires are positioned at different heights of the interposer wiring layer, and the plurality of the sub-connecting wires are connected sequentially based on the height of the interposer wiring layer. When the test potentials of the plurality of the test points indicate an open circuit connection, the interposer is indicated to be fragmented or have a crack.

Optionally, the sub-connecting wires of the plurality of the test points are displayed as a serpentine shape on a cross-section of the interposer according to a wiring distribution sequence of the interposer wiring layer.

Optionally, the plurality of the test points at least include the first test point, the second test point, and the third test point.

The position interval between the first test point and the second test point on the interposer is the first value, the position interval between the first test point and the third test point on the interposer is the second value, and the position interval between the second test point and the third test point on the interposer is the third value. The second value and the third value are determined based on the first value, and the second value is equal to the third value.

In response to the first test point and the second test point being in the open circuit connection, the third test point is determined as the first test point or the second test point.

Optionally, in a distribution direction of the plurality of the test points around the interposer, the first test point and the second test point are respectively positioned at a start point and an end point, and the first value is a maximum value of the position interval on the interposer.

Optionally, the interposer wiring layer includes the first intermediate layer and the second intermediate layer bonded below the first intermediate layer, and an electrical connecting wire of the first intermediate layer is in communication with an electrical connecting wire of the second intermediate layer.

The bonding quality of the first intermediate layer and the second intermediate layer is determined according to the test potentials of the plurality of the test points.

Optionally, a plurality of sub-connecting wires of corresponding test points constitute a comb-shaped short-circuit measurement structure, and a comb-shaped short-circuit measurement structure between adjacent test points is in open-circuit connection. When the test potentials of the plurality of the test points indicate a short-circuit connection, the plurality of the test points are indicated to be short-connected at front of the interposer.

Alternatively, the serpentine open-circuit measurement structure with stacked through vias is correspondingly provided between adj acent test points. When the test potentials of the plurality of the test points indicate the open circuit connection, the plurality of the test points are indicated to be open-connected at the front of the interposer.

Optionally, a plurality of through-vias electrodes electrically connected with the test points are provided on the interposer, and a plurality of interconnection structures through the chips are provided on the chips.

The chips are bonded to the interposer, a bottom of the interconnection structures is electrically connected with the through-vias electrodes, and a top of the interconnection structures is provided with interconnection solder balls.

When a voltage is applied to the test points and the interconnecting solder balls electrically connected to the test points, and test potentials of the interconnecting solder balls electrically connected with the test points indicate a preset potential, the interconnecting solder balls are indicated to be electrically connected with the interconnection structures.

Optionally, solder balls at two ends of a chip circuit structure are served as circuit testing solder balls, a chip circuit testing structure is provided between the circuit testing solder balls, the chip circuit testing structure is configured to electrically connect the circuit testing solder balls, and when test potentials of test points electrically connected with the circuit testing solder balls indicate the open circuit connection, the chip circuit structure is indicated to be damaged.

Optionally, interposer solder balls are provided on through-vias electrodes at a side of the interposer away from the chips, an interposer solder ball testing structure is provided on solder balls of the through-vias electrodes that are provided with the interposer solder balls, the interposer solder balls are configured for short-connecting the interposer solder ball testing structure, and when a test voltage is applied to the interposer solder balls, and test potentials between the interposer solder balls indicate that the interposer solder balls are short-connected, the interposer solder balls are indicated to be electrically connected with the through-vias electrodes.

Optionally, the chip testing structure further comprises a substrate. An interposer structure and bottom solder balls at bottom of the interposer structure are provided in the substrate, and the interposer is connected with the interposer structure of the substrate to the bottom solder balls based on the interposer solder balls.

When a test voltage is applied on the bottom solder balls to through-vias electrodes that are short-connected, and test potentials between the bottom solder balls indicate that the bottom solder balls are short-circuit, the bottom solder balls are indicated to be electrically connected with the interposer.

Optionally, when a test voltage is applied on the bottom solder balls to interconnecting solder balls that are short-connected, and the test potentials between the bottom solder balls indicate that the bottom solder balls are short-circuit, the bottom solder balls are indicated to be electrically connected with the chips.

Optionally, when a test voltage is applied on the bottom solder balls to a short-connected circuit that is mixed-connected with the interconnecting solder balls and through-vias electrodes, and the test potentials between the bottom solder balls indicate that the bottom solder balls are short-circuit, the bottom solder balls are indicated to be electrically connected with the chips and the interposer.

In the second aspect, the embodiments of the present disclosure provide a chip testing method, which includes: providing the chip testing structure, and measuring test potentials of the plurality of the test points.

The chip testing structure includes an interposer, a plurality of chips on the interposer, and a plurality of test points on the interposer. The plurality of the test points are connected in series, an electrical connecting wire of the plurality of the test points is provided in an interposer wiring layer of the interposer, and an electrical connecting wire of adj acent test potentials comprises a plurality of sub-connecting wires, different sub-connecting wires are positioned at different heights of the interposer wiring layer, and the plurality of the sub-connecting wires are connected sequentially based on the height of the interposer wiring layer.

When the test potentials of the plurality of the test points indicate an open circuit connection, the interposer is indicated to be fragmented or have a crack.

Optionally, the measuring test potentials of the plurality of the test points, includes:
in a distribution direction of the plurality of the test points around the interposer, determining the first test point and the second test point; and
measuring test potentials of the first test point and the second test point.

During an initial test, a position interval between the first test point and the second test point on the interposer is the first value.

Optionally, in response to the test potentials of the first test point and the second test point indicating the open circuit connection, the third test point is determined as the first test point or the second test point, and the third test point is determined based on the first value.

Optionally, the interposer wiring layer includes the first intermediate layer and the second intermediate layer, the second intermediate layer is bonded below the first intermediate layer, and an electrical connecting wire of the first intermediate layer is in communication with an electrical connecting wire of the second intermediate layer.

The measuring test potentials of the plurality of the test points, includes:
determining a bonding quality of the first intermediate layer and the second intermediate layer according to the test potentials of the plurality of the test points.

Optionally, on a side of the interposer where test points are provided, the test points are provided with a comb-shaped short-circuit measurement structure, the comb-shaped short-circuit measurement structure corresponds to a plurality of sub-connecting wires of the test points, and a comb-shaped short-circuit measurement structure of adjacent test points is open-circuit.

The measuring test potentials of the plurality of the test points, includes: measuring the test potentials of the plurality of the test points.

When the test potentials of the plurality of the test points indicate a short-circuit connection, the plurality of the test points are indicated to be short-connected on the side of the interposer where the test points are provided.

Optionally, on a side of the interposer where test points are provided, a serpentine open-circuit measurement structure with stacked through vias is provided between adjacent test points, and the serpentine open-circuit measurement structure with the stacked through vias corresponds to the plurality of the sub-connecting wires of the adj acent test points.

The measuring test potentials of the plurality of the test points, includes: measuring test potentials of the adjacent test points.

When the test potentials of the adjacent test points indicate an open circuit connection, the adjacent test points are indicated to be open-connected on the side of the interposer where the test points are provided.

Optionally, the chip testing method further includes: thinning the interposer, and leaking out a plurality of through-vias electrodes electrically connected with the test points.

The chips are provided with a plurality of interconnection structures through the chips, the chips are bonded to the interposer so that a bottom of the interconnection structures is connected with the through-vias electrodes, and a top of the interconnection structures is provided with interconnection solder balls.

The measuring test potentials of the plurality of the test points, includes: applying a voltage to the test points and the interconnecting solder balls electrically connected with the test points, and measuring test potentials of the interconnecting solder balls electrically connected with the test points.

When the test potentials of the interconnecting solder balls electrically connected with the test points indicate a preset potential, the interconnecting solder balls are indicated to be electrically connected with the interconnection structures.

Optionally, the chips include circuit testing solder balls, the circuit testing solder balls are solder balls at two ends of a chip circuit structure, and a chip circuit testing structure is provided between the circuit test solder balls so as to electrically connect the circuit testing solder balls.

The measuring test potentials of the plurality of the test points, further includes: measuring the test potentials of the plurality of the test points that are electrically connected with the circuit testing solder balls.

When the test potentials indicate an open circuit connection, the chip circuit structure is indicated to be damaged.

Optionally, the chip testing method further includes:
flipping the interposer on a substrate;
forming interposer solder balls on through-vias electrodes at a side of the interposer away from the chips;
forming an interposer solder ball testing structure on solder balls of the through-vias electrodes where the interposer solder balls are formed, and wherein the interposer solder ball testing structure is short-connected.

The measuring test potentials of the plurality of the test points further includes: applying a test voltage to the interposer solder balls, and measuring test potentials of the interposer solder balls.

When the test potentials between the interposer solder balls indicate that the interposer solder balls are short-connected, the interposer solder balls are indicated to be electrically connected with the through-vias electrodes.

Optionally, the substrate includes an interposer structure and bottom solder balls at bottom of the interposer structure, and the interposer is connected with the interposer structure of the substrate to the bottom solder balls based on the interposer solder balls.

The measuring test potentials of the plurality of the test points, further includes: applying a test voltage on the bottom solder balls to through-vias electrodes that are short-connected, and measuring test potentials between the bottom solder balls.

When the test potentials between the bottom solder balls indicate that the bottom solder balls are short-circuit, the bottom solder balls are indicated to be electrically connected with the interposer.

Optionally, the measuring test potentials of the plurality of the test points further includes: applying a test voltage on the bottom solder balls to the interconnecting solder balls that are short-connected, and measuring the test potentials between the bottom solder balls.

When the test potentials between the bottom solder balls indicate that the bottom solder balls are short-circuit, the bottom solder balls are indicated to be electrically connected with the chips.

Optionally, the measuring test potentials of the plurality of the test points further includes: applying a test voltage on the bottom solder balls to a short-connected circuit that is mixed-connected with the interconnecting solder balls and through-vias electrodes, and measuring the test potentials between the bottom solder balls.

When the test potentials between the bottom solder balls indicate that the bottom solder balls are short-circuit, the bottom solder balls are indicated to be electrically connected with the chips and the interposer.

The chip testing structure provided by the embodiments of the present disclosure, includes an interposer, and a plurality of chips on the interposer, and a plurality of test points on the interposer. The plurality of the test points are connected in series, an electrical connecting wire of the plurality of the test points is provided in an interposer wiring layer of the interposer, and an electrical connecting wire of adj acent test potentials comprises a plurality of sub-connecting wires, different sub-connecting wires are positioned at different heights of the interposer wiring layer, and the plurality of the sub-connecting wires are connected sequentially based on the height of the interposer wiring layer. Thus, when the test potentials of the plurality of the test points indicate an open circuit connection, the interposer is indicated to be fragmented or have a crack.

It can be seen that the embodiments of the present disclosure, based on the plurality of test points that are connected in series on the interposer, can accurately and efficiently determine whether the interposer is fragmented or has a crack by testing the potentials of the plurality of test points, so as to implement the detection for the interposer in the whole process of the packaging procedure.

### BRIEF DESCRIPTION OF THE DRAWINGS

In order to illustrate the technical solution in the embodiments of the present disclosure more clearly, the drawings that are needed to be used in the description of the embodiments will be briefly introduced below. Obviously, the drawings described below are only the embodiments of the present disclosure, and for those skilled in the art, other drawings can be obtained according to the provided drawings without creative labor.
FIG. 1 is a schematic diagram of a test structure on a wafer;
FIG. 2 is a top-down schematic diagram of a chip testing structure provided by the embodiment of the present disclosure;
FIG. 3 is a cross-sectional schematic diagram of a chip testing structure provided by the embodiment of the present disclosure;
FIG. 4 is an optional structural schematic diagram of an interposer provided by the embodiment of the present disclosure;
FIG. 5 is an optional schematic diagram of an open and short circuit testing structure corresponding to test points provided by the embodiment of the present disclosure;
FIG. 6 is an optional schematic diagram of a chip testing structure provided by the embodiment of the present disclosure;
FIG. 7 is another optional schematic diagram of a chip testing structure provided by the embodiment of the present disclosure;
FIG. 8 is another optional schematic diagram of a chip testing structure provided by the embodiment of the present disclosure;
FIG. 9 is another optional schematic diagram of a chip testing structure provided by the embodiment of the present disclosure; and
FIG. 10 is an optional flowchart schematic diagram of a chip testing method provided by the embodiment of the present disclosure.

### DETAILED DESCRIPTION

The technical solution in the embodiments of the present disclosure will be clearly and completely described below in conjunction with the drawings in the embodiments of the present disclosure. Obviously, the embodiments described are only part of the embodiments of the present disclosure, instead of all embodiments. Based on the embodiments in the present disclosure, all other embodiments obtained by a person skilled in the art without creative labor belong to the protection scope of the present disclosure.

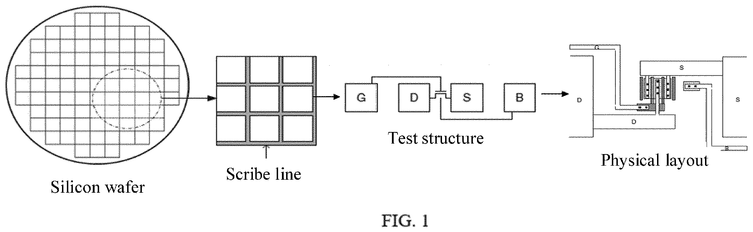

In order to test whether the design of integrated circuits is successful, taping out the wafer product is required, and after taping out the wafer product and before the quality inspection, the electrical parameters of a specific test structure are measured, so as to detect the process of each wafer product, evaluate the quality and stability of the semiconductor manufacturing process, and determine whether the wafer product meets the electrical specification requirements of the process technology platform. The method of testing products is referred as the wafer acceptance test (WAT). The WAT test structure is generally set on the wafer scribe line, in schematic diagram of the test structure on the wafer as illustrated in FIG. 1, the silicon wafer is a whole wafer product, each small grid on the silicon wafer represents a chip. The position circled by dotted lines on the silicon wafer is magnified, the scribe line between the chips can be seen, and then the silicon wafer is placed under the microscope, and the WAT test structure in the scribe line can be seen. In FIG. 1, G, D, S, B are the top metal windows, usually called the bonding PAD, and the bonding PAD is correspondingly designed with a physical layout in the scribe line. Moreover, between the PAD and PAD of the test structure, different test structures can form a group of test modules, and each group of test modules has a different name, so that each wafer contains many different WAT test modules.

With the development of the semiconductor technology, the packaging process has a variety of packaging technologies in the terms of implementation methods, such as flip chip, bumping, wafer-level packaging, 2.5D packaging (CoWoS, RDL, and etc.), 3D packaging (TSV), and etc.

Based on the silicon wafer illustrated in FIG. 1, the CoWoS (chip-on-wafer-on-substrate) packaging technology in 2.5D packaging is taken as an example to illustrate the chip packaging process. During the chip packaging, based on the high fine-pitch wiring capability of the interposer, the chip can be stacked with a wafer through the interposer, in which the connection part between the chip and the interposer is called the ubump, and the ubump is formed of a pair of metal leads with a solder welded in the middle, and then the filler is filled to protect the chip and the connected structure to form a CoW (chip-on-wafer) wafer. Then, the CoW wafer is connected to the carrier board and are polished chemically and mechanically, the interposer is thinned to expose the through-silicon vias (TSVs), and then the wiring is performed and solder balls are soldered according to the exposed through-silicon vias. Then, the CoW wafer is transferred from the carrier board to the tape, and the chip is obtained by cutting the wafer, and the chip is taken off from the tape and flip-chip mounted on the substrate to form the CoWoS structure. Finally, a protection structure is added and the thermal interface metal is used to fill the gap between the protective cover and the chip, therefore, the chip packaging is completed.

It should be noted that, by steps such as illumination through the mask, the designed integrated circuit is projected onto the interposer. Because the size of the mask is fixed, for example, the size is 26mm*33mm, and the area of the interposer is larger, thus the illumination splicing on the interposer is required to lithography the integrated circuit onto an interposer having a larger area. However, the quality of the splicing area on the interposer is difficult to test, resulting in the quality problem in the packaged chip. In addition, in the process of packaging, a bonding connection between the interposer and the substrate exists, making the overall stress risk corresponding to the interposer high, also causing the interposer to be fragmented or have a crack, and causing a poor quality of the packaged chip. Therefore, the interposer is required to be tested during the whole process of packaging, in order to determine whether the interposer is fragmented or has a crack, thereby quickly locating the problem point.

Based on this, the embodiments of this company provide a new chip testing structure, which includes an interposer, a plurality of chips on the interposer, and a plurality of test points on the interposer. The plurality of the test points are connected in series, an electrical connecting wire of the plurality of the test points is provided in an interposer wiring layer of the interposer, and an electrical connecting wire of adjacent test potentials includes a plurality of sub-connecting wires, different sub-connecting wires are positioned at different heights of the interposer wiring layer, and the plurality of the sub-connecting wires are connected sequentially based on the height of the interposer wiring layer. Thus, when the test potentials of the plurality of the test points indicate an open circuit connection, the interposer is indicated to be fragmented or have a crack.

It can be seen that the embodiment of the present disclosure, based on the plurality of test points connected in series on the interposer, and by testing the potentials of the plurality of test points, can accurately and efficiently determine whether the interposer is fragmented or has a crack, so as to implement the detection for the interposer in the whole process of packaging.

In addition, it should be noted that the detection for the interposer can be implemented by monitoring the electrical characteristic parameters during the chip packaging process and monitoring the connectivity of the various components. However, because the wafer is required to be cut in the packaging process, and the test structure provided on the wafer scribe line may be cut off, thus, based on the test structure provided on the wafer scribe line, the detection for the interposer is difficult to be implemented in the whole process of packaging, and then the problem point is difficult to be located. Moreover, because bumps are not made on the front of the interposer generally, the front side test for the interposer cannot be implemented.

In the optional implementations of the present disclosure, the location of the problem point can be implemented based on the plurality of test points positioned on the interposer. While, the test for the bumps of the interposer is implemented based on the electrical connection wires corresponding to the plurality of test points that are provided in the interposer wiring layer, and the front test for the interposer is implemented based on the test structure corresponding to the plurality of test points.

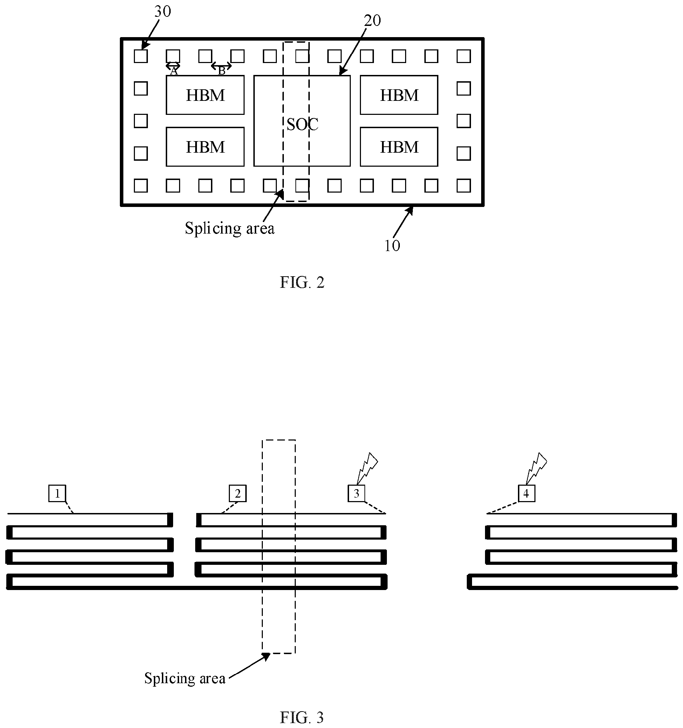

FIG. 2 illustratively illustrates a top-down schematic diagram of a chip testing structure provided by the embodiment of the present disclosure. As illustrated in FIG. 2, the chip testing structure includes: an interposer 10, a plurality of chips 20 positioned on the interposer, and a plurality of test points 30 positioned on the interposer.

The interposer 10 serves as a packaging carrier, which is a core structure in the chip packaging process, and provides the electrical connection, protection, support, and heat dissipation for the chips. The interposer may be e.g., a silicon interposer. In an optional implementation, through silicon vias (TSV) may be provided on the interposer to implement the interconnection of the chips, the wafer, etc.

The plurality of chips 20 may be set according to the design requirements, and FIG. 2 is illustrated by only taking the high-bandwidth memory (HBM) and the system-on-chip (SOC) as an example. The plurality of chips 20 may further be chips such as GPUs, etc.

The plurality of test points 30 may be understood as a metal window of the WAT test structure (WAT-PAD), which evenly surrounds the edge of the interposer. The plurality of test points in the embodiments of the present disclosure are connected in series, and the electrical connecting wire of the plurality of test points is provided in the interposer wiring layer of the interposer, and the electrical connecting wire of adjacent test potentials includes a plurality of sub-connecting wires, and the different sub-connecting wires are positioned at different heights of the interposer wiring layers, and the plurality of sub-connecting wires are connected sequentially based on the height of the interposer wiring layer.

Different from providing the test structure on the scribe line of the wafer, the plurality of test points in the embodiments of the present disclosure are positioned on the interposer, and the electrical connecting wire of the plurality of test points is provided on the interposer wiring layer, so that the plurality of test points can be avoided from being cut off during the cutting process of the wafer, and then in the whole process of packaging of the chip, the plurality of test points can be used to test and monitor the interposer. Because the plurality of test points are evenly distributed in a circle of the edge of the interposer, the electrical characteristic parameters in the chip packaging process and the connectivity of various components can be monitored based on the plurality of test points provided. Therefore, when the test potentials of the plurality of test points indicate an open circuit connection, the interposer is indicated to be fragmented or have cracks, implementing an accurate and efficient location of problem points in the process development.

It can be seen that the embodiments of the present disclosure, based on the plurality of test points that are connected in series on the interposer, can accurately and efficiently determine whether the interposer is fragmented or has a crack by testing the potentials of the plurality of test points, so as to implement the detection for the interposer in the whole process of the packaging procedure.

In some embodiments, FIG. 3 illustratively illustrates a cross-sectional schematic diagram of a chip testing structure provided by the embodiment of the present disclosure. As illustrated in FIG. 3, 1, 2, 3 and 4 are the plurality of different test points. In conjunction with FIG. 2, the distribution positions of the test points 1, 2, 3 may be a side corresponding to the long edge of the interposer, the distribution position of the test point 4 may be a side corresponding to the short edge of the interposer, and the connecting wires with different thicknesses in FIG. 3 are sub-connecting wires of the test points.

The interposer wiring layer of the interposer may be distributed in a plurality of layers, and the sub-connecting wires with the same thickness in FIG. 3 are on the same layer of the interposer wiring layer of the interposer. The black box points are the connecting points of the sub-connecting wires positioned in different layers. It can be seen that the sub-connecting wires of the plurality of test points in the embodiment of the present application are connected in a serpentine shape on the cross-section of the interposer according to the wiring distribution sequence of the interposer wiring layer, so that the test potentials of the plurality of test points can characterize the state of the interposer being fragmented or having cracks.

In the process of packaging, for example, before completing the CoW process, the interposer needs to be tested for quality, so as to detect whether the interposer having a splicing area is fragmented or has cracks. In the embodiment of the present disclosure, based on the plurality of test points connected in series on the interposer, an open-circuit and/or short-circuit test can be performed on the plurality of test points, so as to determine whether the interposer having a splicing area is fragmented or has cracks.

In some embodiments, when the interposer is tested for quality, the plurality of test points may at least include the first test point, the second test point, and the third test point. The position interval between the first test point and the second test point on the interposer is the first value, the position interval between the first test point and the third test point on the interposer is the second value, and the position interval between the second test point and the third test point on the interposer is the third value. The second value and the third value are determined based on the first value, and the second value is equal to the third value.

In response to the first test point and the second test point being in the open circuit connection, the third test point is determined as the first test point or the second test point.

It should be noted that the quality test for the interposer may be performed in various steps of the chip packaging process, so as to ensure that the interposer entering into respective processe is a qualified interposer. Therefore, the timing of the quality test for the interposer is not limited by the embodiments of the present disclosure.

In other embodiments, in the distribution direction of the plurality of test points around the interposer, the first test point and the second test point may be positioned at the starting point and the end point respectively, and the first value is the maximum value of the position intervals on the interposer.

In order to facilitate the understanding of the quality test for the interposer based on the test points, the test points illustrated in FIG. 3 are taken as an example to describe.

When the test point 1 and the test point 4 are tested, in response to the test potential indicate the open circuit, it indicates that the fragmentation or crack of the interposer may exist from the position of the interposer corresponding to the test point 1 to the position of the interposer corresponding to the test point 4, so that new test points may be determined again by taking half of the path based on the position interval between the test point 1 and the test point 4, and the quality test is performed again. For example, the new test points may be determined as the test point 2 and the test point 3. Thus, the test potential between the test point 1 and the test point 2, and the test potential between the test point 3 and the test point 4 may be tested respectively. In response to the test potentials indicating the short connection, no fragmentation or crack of interposer exists between the test point 1 and the test point 2 on the interposer, and between the test point 3 and the test point 4 on the interposer. Then the test potential between the test point 2 and the test point 3 is further measured, and in response to indicating the open-circuit connection, the fragmentation or crack of the interposer can be accurately determined to exist between the test point 2 and the test point 3 on the interposer.

Understandably, due to the larger area of the interposer, when the plurality of test points on the interposer are designed, different test points may be evenly distributed at the edge position of the interposer, so as to perform the quality test for the interposer. Optionally, the plurality of test points may also be designed inside the interposer, which is not limited by the embodiments of the present disclosure, and the distribution position of the test points can be placed correspondingly according to the design requirements.

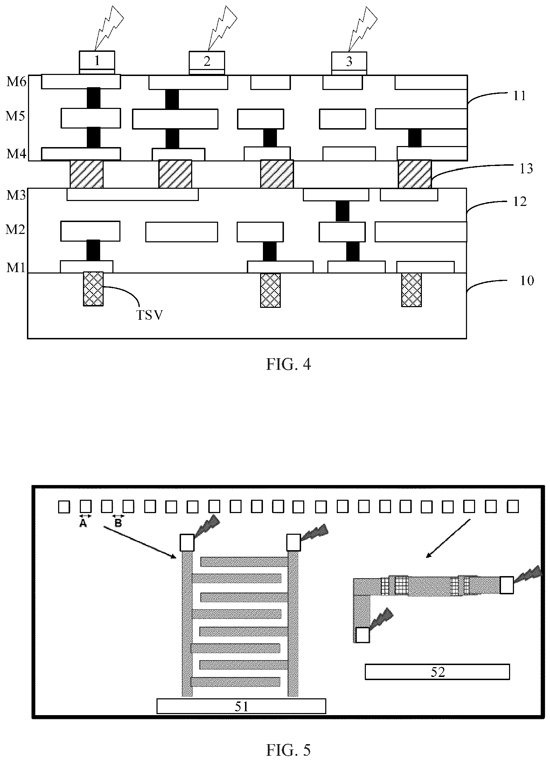

In some embodiments, FIG. 4 illustrates an optional structural schematic diagram of the interposer of the embodiment of the present disclosure. As illustrated in FIG. 4, the interposer 10 may be constituted by a stacking structure, and the interposer 10 includes: the first intermediate layer 11 and the second intermediate layer 12 stacked below the first intermediate layer 11. The first intermediate layer and the second intermediate layer may be stacked by hybrid bonding 13. Moreover, in order to implement the electrical function of the interposer in the stacked configuration, the electrical connecting wires of the first intermediate layer may be in communication with the electrical connecting wires of the second intermediate layer through the hybrid bonding 13.

For the interposer in the stacked configuration, the bonding of different intermediate layers is implemented by the hybrid bonding, while the bonding of the hybrid bonding has a problem of the poor bonding caused by stress, or the bonding quality is unqualified, which causes a poor electrical performance of the interposer. Therefore, in the embodiments of the present disclosure, the bonding quality of the first intermediate layer and second intermediate layer can be determined according to the test potentials of the plurality of test points on the interposer. In an optional example, in response to the test potentials of the plurality of test points indicating the open-circuit connection, then the corresponding bonding quality between the first intermediate layer and second intermediate layer is indicated to be unqualified. For example, the test point 1 and the test point 3 are tested, and in response to the test potential indicating the open circuit, the bonding quality of the part corresponding to the test point 1 and the test point 3 of the interposer in the stacked configuration is poor, and then the test is repeated based on the above-mentioned method of re-determining the test points, which can accurately determine the bonding point that does not reach the standard in the interposer constituting the stacked configuration.

In some embodiments, the front of the interposer is provided with a conventional open and short circuit testing structure, and the conventional open and short circuit testing structure may be provided below or around the test points according to the design requirements. FIG. 5 illustrates an optional schematic diagram of an open and short circuit testing structure corresponding to the test points. As illustrated in FIG. 5, the open and short circuit testing structure may be constituted by a plurality of sub-connecting wires based on the test points. As an optional implementation, the plurality of sub-connecting wires corresponding to the test points may constitute a comb-shaped short-circuit measurement structure (as indicated by the number 51 in the figure), and the comb-shaped short-circuit measurement structure between adjacent test points is in the open-circuit connection. Thus, when the open and short circuit testing structure of the test points is tested, in response to the test potentials of the plurality of test points indicating the short-circuit connection, the plurality of test points are indicated to be short-connected at the front of the interposer.

As another optional implementation, a serpentine open-circuit measurement structure with stacked through vias (as indicated by the number 52 in the figure) may be correspondingly provided between adjacent test points. Thus, when the open and short circuit testing structure of the test point is tested, in response to the test potentials of the plurality of test points indicate the open-circuit connection, the plurality of test points are indicated to be open-connected at the front of the interposer.

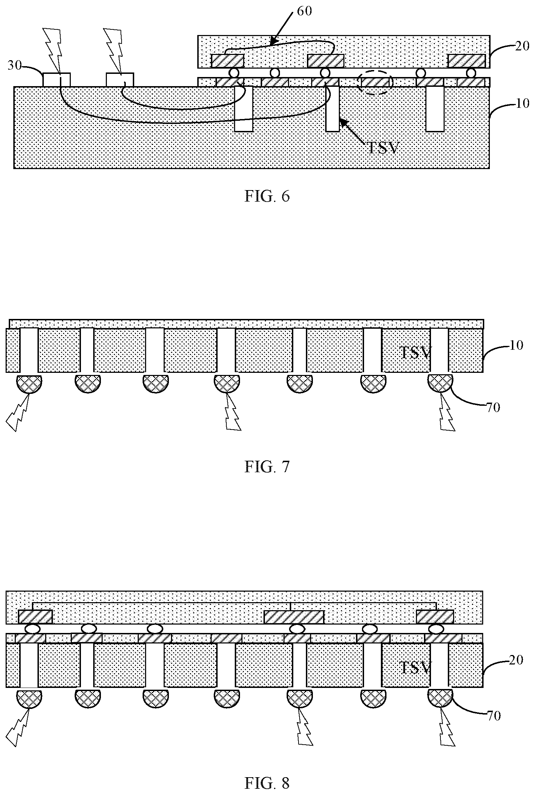

In some embodiments, the interposer may be provided with a plurality of through-vias electrodes electrically connected with the plurality of test points, and the chip may be provided with a plurality of interconnection structures through the chip. In an optional schematic diagram of a chip testing structure illustrated in FIG. 6, the TSV represents through vias on the interposer, and the position circled by dotted lines is the interconnection structure of the chip. Referring to FIG. 6, the chip is bonded to the interposer, the bottom of the interconnection structure is connected with the through-vias electrodes, and the top of the interconnection structure may be provided with interconnect solder balls (as illustrated as the circles in FIG. 6). When a voltage is applied to the test points and the interconnection solder balls electrically connected to the test points, the test potentials of the interconnection solder balls electrically connected to the test points may indicate a preset potential, the interconnection solder balls are indicated to be electrically connected with the interconnection structure. The preset potential may be a pre-set potential range, such as a voltage range of 1V~2V.

Understandably, in the process of packaging a chip, the interposer is bonded with chips, etc., and the overall stress risk is high. For example, after obtaining a CoW wafer in the packaging process of CoWOS, a frontal interconnection test is required to be performed on the CoW wafer, so as to determine the bonding interconnection quality of the chip. Therefore, based on the structure as illustrated in FIG. 6, the test for the bonding interconnection quality of the ubumps can be implemented by using a Kelvin four-terminal test method, so as to determine the electrical connection performance of the interconnection structure of the interconnection solder balls and the chip, and the electrical connection performance includes such as a virtual connection, a short connection, and etc.

In some embodiments, continuing with reference to FIG. 6, the solder balls at two ends of the chip circuit structure may be served as circuit testing solder balls, and the chip circuit testing structure (as indicated by the number 60 illustrated in FIG. 6) may be provided between the circuit testing solder balls, wherein the chip circuit testing structure is configured for electrically connecting with the circuit testing solder balls. When the test potentials of the test points electrically connected with the circuit testing solder balls indicates open-circuit connection, the chip circuit structure is indicated to be damaged.

It should be noted that, implementing a test for the chip circuit structure based on the test points electrically connected with the circuit testing solder balls may be performed in the chip packaging process, and after the test for the chip circuit structure, the test points of the interposer can be used to retest whether a fragmentation or crack of the interposer is caused in the chip packaging process, so as to determine whether the stress in the chip packaging process causes an effect on the interposer.

In some embodiments, FIG. 7 illustratively illustrates another optional schematic diagram of a chip testing structure. As illustrated in FIG. 7, interposer solder balls (as indicated by the number 70 in the figure) are provided on the through-vias electrodes on the side of the interposer away from the chip, and an interposer solder ball testing structure (the structure marked a lightning symbol in the figure) is provided on the solder balls of the through-vias electrodes where the interposer solder balls are provided. The interposer solder balls are configured to be short-connected with the interposer solder ball testing structure, and when a test voltage is applied to the interposer solder balls, and the test potentials between the interposer solder balls indicate that the interposer solder balls are short-connected, the interposer solder balls are indicated to be electrically connected to the through-vias electrodes.

Optionally, FIG. 8 illustratively illustrates another optional schematic diagram of the chip testing structure. As illustrated in FIG. 8, the test principle of testing the electrical connection between the interposer solder balls and the through-vias electrodes may be used, and when the chip has a chip circuit structure, whether the stress causes an effect on the bonding of the chip during the chip packaging process is determined by using interposer solder balls to test the bonding quality of the hybrid bonding and through-vias electrodes that implement the bonding.

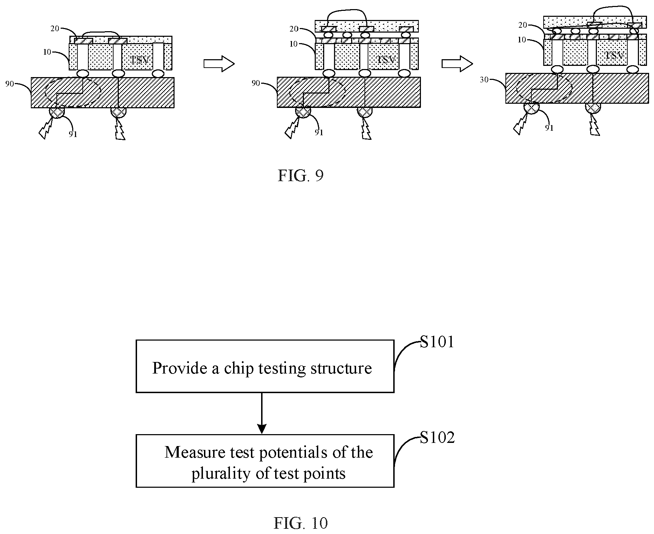

In some embodiments, a chip is required to be installed on a substrate to obtain a complete chip after packaging, and then a chip testing structure may further include a substrate. FIG. 9 illustratively illustrates another optional schematic diagram of a chip testing structure. As illustrated in FIG. 9, the substrate 90 is provided with an interposer structure (the position circled by dotted lines in the figure) and bottom solder balls (as indicated by the number 91 in the figure) positioned at the bottom of the interposer structure, and the interposer may be connected to the bottom solder balls based on the interposer solder balls and the interposer structure of the substrate.

As an optional implementation, a test voltage may be applied to the bottom solder balls to the through-vias electrodes that are short-connected. When the test potentials between the bottom solder balls indicate that the bottom solder balls are short-circuit, the bottom solder balls are indicated to be electrically connected with the interposer. Understandably, when the test potentials between the bottom solder balls indicate that the bottom solder balls are short-circuit, then the applied test voltage may be transmitted based on the path, that is, there is no possibility of being fragmented or having a crack for the interposer bonded with the substrate t, i.e., the interposer is not damaged by the overall stress during the chip packaging process.

As an optional implementation, a test voltage may be applied to the bottom solder balls to interconnection solder balls that are short-connected. When the test potentials between the bottom solder balls indicates that the bottom solder balls are short-circuit, the bottom solder balls are indicated to be electrically connected with the chip. Understandably, when the test potentials between the bottom solder balls indicate that the bottom solder balls are short-circuit, the applied test voltage may be transmitted based on the path, i.e., the chip bonded with the interposer is not damaged during the packaging process.

As another optional implementation, a test voltage may be applied to the bottom solder balls to a short-connected circuit that is mixed-connected with the interconnecting solder balls and through-vias electrodes. When the test potentials between the bottom solder balls indicate that the bottom solder balls are short-circuit, then the bottom solder balls are indicated to be electrically connected with the chip and the interposer. Understandably, when the test potentials between the bottom solder balls indicate that the bottom solder balls are short-circuit, then the applied test voltage may be transmitted based on the path, that is, the electrical connection function of the chip after packaging is not damaged, and the quality of the chip after packaging satisfies the standard.

It can be seen that the embodiments of the present disclosure, based on the plurality of test points that are connected in series on the interposer, can accurately and efficiently determine whether the interposer is fragmented or has a crack by testing the potentials of the plurality of test points, so as to implement the detection for the interposer in the whole process of the packaging procedure.

The embodiment of the present disclosure further provides a chip testing method, and FIG. 10 illustratively illustrates an optional flowchart schematic diagram of a chip testing method. As illustrated in FIG. 10, the following steps may be included. The content described below can be corresponded to and referred to the above description.

Step S101, providing a chip testing structure.

In conjunction with FIG. 2, the chip testing structure may include an interposer, a plurality of chips positioned on the interposer, and a plurality of test points positioned on the interposer. The plurality of test points are connected in series, and the electrical connecting wires of the plurality of test points are provided in an interposer wiring layer of the interposer, and the electrical connecting wires of adjacent test potentials include a plurality of sub-connecting wires, the different sub-connecting wires are positioned at different heights of the interposer wiring layers, and the plurality of sub-connecting wires are connected sequentially based on the heights of the interposer wiring layers.

Step S 102, measuring test potentials of the plurality of test points.

When the test potentials of the plurality of test points indicate the open-circuit connection, the interposer is indicated to be fragmented or have a crack.

It can be seen that, based on the provided chip testing structure, the embodiments of the present disclosure can accurately and efficiently determine whether the interposer is fragmented or has a crack by testing the potentials of the plurality of test points, and implement the detection for the interposer in the whole process of the packaging procedure.

Optionally, the steps for measuring the test potentials of the plurality of test points may include:
in the distribution direction of the plurality of test points around the interposer, determining the first test point and the second test point; and
measuring the test potentials of the first test point and the second test point.

During the initial test, the position interval between the first test point and the second test point on the interposer is the first value.

Optionally, in response to the test potentials of the first test point and the second test point indicating the open-circuit connection, the third test point is determined as the first test point or the second test point, and the third test point is determined and obtained based on the first value.

Optionally, the interposer wiring layer includes the first intermediate layer and the second intermediate layer, and the second intermediate layer is bonded below the first intermediate layer, and the electrical connecting wire of the first intermediate layer is in communication with the electrical connecting wire of the second intermediate layer.

The step for measuring the test potentials of the plurality of test points further includes:
determining the bonding quality of the first intermediate layer and the second intermediate layer according to the test potentials of the plurality of test points.

Optionally, on the side of the interposer where the test points are provided, the test points are provided with a comb-shaped short-circuit measurement structure, the comb-shaped short-circuit measurement structure corresponds to the plurality of the sub-connecting wires of the test points, and the comb-shaped short-circuit measurement structure of adjacent test points is open-circuit connected.

The step for measuring the test potentials of the plurality of test points further includes:
measuring the test potentials of the plurality of the test points. When the test potentials of the plurality of the test points indicate the short-circuit connection, the plurality of the test points are indicated to be short-connected on the side of the interposer where the test points are provided.

Optionally, on the side of the interposer where the test points are provided, a serpentine open-circuit measurement structure with stacked through-vias is provided between adjacent test points, and the serpentine open-circuit measurement structure with the stacked through-vias corresponds to the plurality of the sub-connecting wires of the adj acent test points.

The step for measuring the test potentials of the plurality of test points includes:
measuring the test potentials of the adjacent test points. When the test potentials of the adjacent test points indicate the open-circuit connection, the adjacent test points are indicated to be open-connected on the side of the interposer where the test points are provided.

Optionally, the chip testing method further includes:
thinning the interposer, and leaking out a plurality of through-vias electrodes electrically connected with the test points. The chips are provided with a plurality of interconnection structures through the chips, the chips are bonded with the interposer so that a bottom of the interconnection structures is connected with the through-vias electrodes, and a top of the interconnection structures is provided with interconnection solder balls.

The step for measuring the test potentials of the plurality of test points includes:
applying a voltage to the test points and the interconnecting solder balls electrically connected with the test points, and measuring the test potentials of the interconnecting solder balls electrically connected with the test points. When the test potentials of the interconnecting solder balls electrically connected with the test points indicate a preset potential, the interconnecting solder balls are indicated to be electrically connected with the interconnection structures.

Optionally, the chip includes circuit testing solder balls, the circuit testing solder balls are solder balls at two ends of a chip circuit structure, and a chip circuit testing structure is provided between the circuit testing solder balls so as to electrically connect the circuit test solder balls.

The step for measuring the test potentials of the plurality of test points further includes:
measuring the test potentials of the plurality of the test points that are electrically connected with the circuit testing solder balls. When the test potentials indicate the open-circuit connection, the chip circuit structure is indicated to be damaged.

Optionally, the chip testing method further includes:
flipping the interposer on a substrate;
forming interposer solder balls on through-vias electrodes at the side of the interposer away from the chip;
forming an interposer solder ball testing structure on solder balls of the through-vias electrodes where the interposer solder balls are formed, and the interposer solder ball testing structure being short-connected.

The step for measuring the test potentials of the plurality of test points further includes:

applying a test voltage to the interposer solder balls, and measuring the test potentials of the interposer solder balls. When the test potentials between the interposer solder balls indicate that the interposer solder balls are short-connected, the interposer solder balls are indicated to be electrically connected with the through-vias electrodes.

Optionally, the substrate includes an interposer structure and bottom solder balls positioned at a bottom of the interposer structure, and the interposer is connected with the bottom solder balls based on the interposer solder balls and the interposer structure of the substrate.

The step for measuring the test potentials of the plurality of test points further includes:
applying a test voltage on the bottom solder balls to the through-vias electrodes that are short-connected, measuring test potentials between the bottom solder balls. When the test potentials between the bottom solder balls indicate that the bottom solder balls are short-circuit, the bottom solder balls are indicated to be electrically connected with the interposer.

Optionally, the step for measuring the test potentials of the plurality of test points further includes:
applying a test voltage on the bottom solder balls to the interconnecting solder balls that are short-connected, and measuring the test potentials between the bottom solder balls. When the test potentials between the bottom solder balls indicate that the bottom solder balls are short-circuit, the bottom solder balls are indicated to be electrically connected with the chip.

Optionally, the step for measuring the test potentials of the plurality of test points further includes:
applying a test voltage on the bottom solder balls to a short-connected circuit that is mixed-connected with the interconnecting solder balls and through-vias electrodes, and measuring the test potentials between the bottom solder balls. When the test potentials between the bottom solder balls indicate that the bottom solder balls are short-circuit, the bottom solder balls are indicated to be electrically connected with the chip and the interposer.

Based on the provided chip testing structure, the embodiments of the present disclosure can accurately and efficiently determine whether the interposer is fragmented or has a crack by measuring the test potentials of the plurality of test points, and implement the detection for the interposer in the whole process of the packaging procedure.

The above describes a plurality of implementations provided by the embodiments of the present disclosure, and the alternative methods introduced by various implementations can be combined and cross-referenced with each other without conflict, thereby extending a plurality of possible implementations, which can be considered as the implementations disclosed in the embodiments of the present disclosure.

Although the embodiments of the present disclosure is disclosed as above, the disclosure is not limited to this. Any person skilled in the art may make various changes and modifications without departing from the spirit and scope of the present disclosure, so the protection scope of the present disclosure shall be subject to the scope limited by the claims.

## Claims

1. A chip testing structure, comprising: an interposer, a plurality of chips on the interposer, and a plurality of test points on the interposer;
wherein the plurality of the test points are connected in series, an electrical connecting wire of the plurality of the test points is provided in an interposer wiring layer of the interposer, and an electrical connecting wire of adjacent test potentials comprises a plurality of sub-connecting wires, different sub-connecting wires are positioned at different heights of the interposer wiring layer, and the plurality of the sub-connecting wires are connected sequentially based on a height of the interposer wiring layer; and
wherein when test potentials of the plurality of the test points indicate an open circuit connection, the interposer is indicated to be fragmented or have a crack.

2. The chip testing structure of claim 1, wherein sub-connecting wires of the plurality of the test points are displayed as a serpentine shape on a cross-section of the interposer according to a wiring distribution sequence of the interposer wiring layer.

3. The chip testing structure of claim 1 or 2, wherein the plurality of the test points at least comprise a first test point, a second test point, and a third test point;
a position interval between the first test point and the second test point on the interposer is a first value, a position interval between the first test point and the third test point on the interposer is a second value, and a position interval between the second test point and the third test point on the interposer is a third value;
the second value and the third value are determined based on the first value, and the second value is equal to the third value; and
in response to the first test point and the second test point being in the open circuit connection, the third test point is determined as the first test point or the second test point.

4. The chip testing structure of claim 3, wherein in a distribution direction of the plurality of the test points around the interposer, the first test point and the second test point are respectively positioned at a start point and an end point, and the first value is a maximum value of position intervals on the interposer.

5. The chip testing structure of any one of claims 1-4, wherein the interposer wiring layer comprises a first intermediate layer and a second intermediate layer bonded below the first intermediate layer, and an electrical connecting wire of the first intermediate layer is in communication with an electrical connecting wire of the second intermediate layer; and
a bonding quality of the first intermediate layer and the second intermediate layer is determined according to the test potentials of the plurality of the test points.

6. The chip testing structure of any one of claims 1-5, wherein a plurality of sub-connecting wires of corresponding test points constitute a comb-shaped short-circuit measurement structure, and a comb-shaped short-circuit measurement structure between adjacent test points is in open-circuit connection; wherein when the test potentials of the plurality of the test points indicate a short-circuit connection, the plurality of the test points are indicated to be short-connected at front of the interposer; or
a serpentine open-circuit measurement structure with stacked through vias is correspondingly provided between adjacent test points; wherein when the test potentials of the plurality of the test points indicate the open circuit connection, the plurality of the test points are indicated to be open-connected at the front of the interposer.

7. The chip testing structure of any one of claims 1-6, wherein a plurality of through-vias electrodes electrically connected with the test points are provided on the interposer, and a plurality of interconnection structures through the chips are provided on the chips;
the chips are bonded to the interposer, wherein a bottom of the interconnection structures is electrically connected with the through-vias electrodes, and a top of the interconnection structures is provided with interconnection solder balls;
when a voltage is applied to the test points and the interconnecting solder balls electrically connected to the test points, and test potentials of the interconnecting solder balls electrically connected with the test points indicate a preset potential, the interconnecting solder balls are indicated to be electrically connected with the interconnection structures.

8. The chip testing structure of claim 7, wherein solder balls at two ends of a chip circuit structure are served as circuit testing solder balls, a chip circuit testing structure is provided between the circuit testing solder balls, the chip circuit testing structure is configured to electrically connect the circuit testing solder balls, and when test potentials of test points electrically connected with the circuit testing solder balls indicate the open circuit connection, the chip circuit structure is indicated to be damaged.

9. The chip testing structure of claim 7, wherein interposer solder balls are provided on through-vias electrodes at a side of the interposer away from the chips, an interposer solder ball testing structure is provided on solder balls of the through-vias electrodes that are provided with the interposer solder balls, the interposer solder balls are configured to be short-connected with the interposer solder ball testing structure, and
when a test voltage is applied to the interposer solder balls, and test potentials between the interposer solder balls indicate that the interposer solder balls are short-connected, the interposer solder balls are indicated to be electrically connected with the through-vias electrodes.

10. The chip testing structure of claim 9, further comprising a substrate,
wherein an interposer structure and bottom solder balls at bottom of the interposer structure are provided in the substrate, and the interposer is connected to the bottom solder balls based on the interposer solder balls and the interposer structure of the substrate; and
when a test voltage is applied on the bottom solder balls to through-vias electrodes that are short-connected, and test potentials between the bottom solder balls indicate that the bottom solder balls are short-circuit, the bottom solder balls are indicated to be electrically connected with the interposer.

11. The chip testing structure of claim 10, wherein when a test voltage is applied on the bottom solder balls to interconnecting solder balls that are short-connected, and the test potentials between the bottom solder balls indicate that the bottom solder balls are short-circuit, the bottom solder balls are indicated to be electrically connected with the chips.

12. The chip testing structure of claim 10, wherein when a test voltage is applied on the bottom solder balls to a short-connected circuit that is mixed-connected with the interconnecting solder balls and through-vias electrodes, and the test potentials between the bottom solder balls indicate that the bottom solder balls are short-circuit, the bottom solder balls are indicated to be electrically connected with the chips and the interposer.

13. A chip testing method, comprising:
providing a chip testing structure, wherein the chip testing structure comprises an interposer, a plurality of chips on the interposer, and a plurality of test points on the interposer; the plurality of the test points are connected in series, an electrical connecting wire of the plurality of the test points is provided in an interposer wiring layer of the interposer, and an electrical connecting wire of adjacent test potentials comprises a plurality of sub-connecting wires, different sub-connecting wires are positioned at different heights of the interposer wiring layer, and the plurality of the sub-connecting wires are connected sequentially based on a height of the interposer wiring layer; and
measuring test potentials of the plurality of the test points, wherein when the test potentials of the plurality of the test points indicate an open circuit connection, the interposer is indicated to be fragmented or have a crack.

14. The chip testing method of claim 13, wherein the measuring test potentials of the plurality of the test points, comprises:
in a distribution direction of the plurality of the test points around the interposer, determining a first test point and a second test point; and
measuring test potentials of the first test point and the second test point;
wherein, during an initial test, a position interval between the first test point and the second test point on the interposer is a first value.

15. The chip testing method of claim 14, wherein in response to the test potentials of the first test point and the second test point indicating the open circuit connection, a third test point is determined as the first test point or the second test point, and the third test point is determined based on the first value.

16. The chip testing method of claim 13, wherein the interposer wiring layer comprises a first intermediate layer and a second intermediate layer, the second intermediate layer is bonded below the first intermediate layer, and an electrical connecting wire of the first intermediate layer is in communication with an electrical connecting wire of the second intermediate layer; and
the measuring test potentials of the plurality of the test points, comprises:
determining a bonding quality of the first intermediate layer and the second intermediate layer according to the test potentials of the plurality of the test points.

17. The chip testing method of claim 13, wherein on a side of the interposer where test points are provided, the test points are provided with a comb-shaped short-circuit measurement structure, the comb-shaped short-circuit measurement structure corresponds to a plurality of sub-connecting wires of the test points, and a comb-shaped short-circuit measurement structure of adjacent test points is in open-circuit connection;
the measuring test potentials of the plurality of the test points, comprises:
measuring the test potentials of the plurality of the test points,
wherein when the test potentials of the plurality of the test points indicate a short-circuit connection, the plurality of the test points are indicated to be short-connected on the side of the interposer where the test points are provided.

18. The chip testing method of claim 13, wherein on a side of the interposer where test points are provided, a serpentine open-circuit measurement structure with stacked through vias is provided between adjacent test points, and the serpentine open-circuit measurement structure with the stacked through vias corresponds to the plurality of the sub-connecting wires of the adjacent test points;
the measuring test potentials of the plurality of the test points, comprises:
measuring test potentials of the adjacent test points,
wherein when the test potentials of the adjacent test points indicate an open circuit connection, the adjacent test points are indicated to be open-connected on the side of the interposer where the test points are provided.

19. The chip testing method of claim 13, further comprising:
thinning the interposer, and leaking out a plurality of through-vias electrodes electrically connected with the test points; wherein the chips are provided with a plurality of interconnection structures through the chips, the chips are bonded to the interposer so that a bottom of the interconnection structures is connected with the through-vias electrodes, and a top of the interconnection structures is provided with interconnection solder balls; and
wherein the measuring test potentials of the plurality of the test points, comprises:
applying a voltage to the test points and the interconnecting solder balls electrically connected with the test points, and measuring test potentials of the interconnecting solder balls electrically connected with the test points,
wherein when the test potentials of the interconnecting solder balls electrically connected with the test points indicate a preset potential, the interconnecting solder balls are indicated to be electrically connected with the interconnection structures.

20. The chip testing method of claim 19, wherein the chips comprise circuit testing solder balls, the circuit testing solder balls are solder balls at two ends of a chip circuit structure, and a chip circuit testing structure is provided between the circuit testing solder balls so as to electrically connect the circuit testing solder balls; and
the measuring test potentials of the plurality of the test points, further comprises:
measuring the test potentials of the plurality of the test points that are electrically connected with the circuit testing solder balls,
wherein when the test potentials indicate an open circuit connection, the chip circuit structure is indicated to be damaged.

21. The chip testing method of claim 19, further comprising:
flipping the interposer on a substrate;
forming interposer solder balls on through-vias electrodes at a side of the interposer away from the chips; and
forming an interposer solder ball testing structure on solder balls of the through-vias electrodes where the interposer solder balls are formed, and wherein the interposer solder ball testing structure is short-connected;
wherein the measuring test potentials of the plurality of the test points further comprises:
applying a test voltage to the interposer solder balls, and measuring test potentials of the interposer solder balls,
wherein when the test potentials between the interposer solder balls indicate that the interposer solder balls are short-connected, the interposer solder balls are indicated to be electrically connected with the through-vias electrodes.

22. The chip testing method of claim 21, wherein the substrate comprises an interposer structure and bottom solder balls at bottom of the interposer structure, and the interposer is connected with the bottom solder balls based on the interposer solder balls and the interposer structure of the substrate; and
the measuring test potentials of the plurality of the test points, further comprises:
applying a test voltage on the bottom solder balls to through-vias electrodes that are short-connected, and measuring test potentials between the bottom solder balls, and
wherein when the test potentials between the bottom solder balls indicate that the bottom solder balls are short-circuit, the bottom solder balls are indicated to be electrically connected with the interposer.

23. The chip testing method of claim 22, wherein the measuring test potentials of the plurality of the test points further comprises:
applying a test voltage on the bottom solder balls to the interconnecting solder balls that are short-connected, and measuring the test potentials between the bottom solder balls, and
wherein when the test potentials between the bottom solder balls indicate that the bottom solder balls are short-circuit, the bottom solder balls are indicated to be electrically connected with the chips.

24. The chip testing method of claim 22, wherein the measuring test potentials of the plurality of the test points further comprises:
applying a test voltage on the bottom solder balls to a short-connected circuit that is mixed-connected with the interconnecting solder balls and through-vias electrodes, and measuring the test potentials between the bottom solder balls, and
wherein when the test potentials between the bottom solder balls indicate that the bottom solder balls are short-circuit, the bottom solder balls are indicated to be electrically connected with the chips and the interposer.
